# FASCICULE DE BREVET EUROPEEN

(11) **EP 0 591 032 B1**
(45) Date de publication et mention de la délivrance du brevet: **03.12.1997**
(21) Numéro de dépôt: 93402337.5
(22) Date de dépôt: 24.09.1993
(51) Int. Cl.: H03F 3/26, H03F 1/34

(54) **Amplificateur de puissance push-pull contre-réactionné par transformateurs en ondes métriques**
Gegentaktleistungsverstärker mit Gegenkopplungstransformatoren für metrische Wellen
Push-pull power amplifier with transformer feedback for metric waves

(30) Priorité: 29.09.1992 FR 9211580
(43) Date de publication de la demande: 06.04.1994
(73) Titulaire: THOMSON-CSF, 75008 Paris (FR)
(72) Inventeur: Byzery, Michel, F-92402 Courbevoie Cédex (FR); Denis, Odette, F-92402 Courbevoie Cédex (FR)
(74) Mandataire: Lincot, Georges

(56) Documents cités:
- US-A- 4 314 252
- US-A- 4 590 434
- HAM RADIO Octobre 1976 , US pages 10 - 25 U.L. ROHDE,DJ2LR, 52 HILLCREST DRIVE, UPPER SADDLE RIVER, NJ 07458 'OPTIMUM DESIGN FOR HIGH-FREQUENCY COMMUNICATIONS RECEIVERS'

## Description

La présente invention telle que définie dans les revendications concerne un amplificateur de puissance push-pull contre-réactionné par transformateurs en ondes métriques. Elle s'applique notamment à la réalisation d'émetteurs radioélectriques portables fonctionnant à proximité d'autres émetteurs.

Il est connu pour constituer l'étage de puissance d'un émetteur haute fréquence d'utiliser des transistors de type bipolaire ou MOS montés en circuit push-pull.

Il est connu d'autre part de contre-réactionner l'amplificateur de puissance par des résistances entre la sortie et l'entrée de l'amplificateur et de coupler l'entrée et la sortie de l'amplificateur à des transformateurs d'adaptation respectivement en entrée et en sortie de l'amplificateur. L'avantage obtenu par l'utilisation d'éléments non dissipatifs sur le bruit de fond et la linéarité d'amplificateurs est connu du document US-A-4 590 434.

La contre-réaction par résistances conduit à une perte de puissance due à la dissipation de puissance supplémentaire dans les résistances de contre-réaction ainsi qu'un accroissement de la dissipation de puissance dans les transistors, ce qui se ressent sur le rendement de l'amplificateur qui est une caractéristique importante pour un amplificateur de puissance.

D'autre part, le comportement de l'amplificateur vis-à-vis de charges désadaptées n'est pas satisfaisant : le courant d'alimentation de l'amplificateur varie en fonction de la charge présente en sortie de l'amplificateur. Toutefois, ce comportement peut être amélioré en diminuant la valeur des résistances de contre-réaction, mais au détriment du gain et du rendement de l'amplificateur.

Le but de l'invention est de pallier les inconvénients précités.

A cet effet, l'invention a pour objet un amplificateur de puissance de type push-pull à deux transistors contre-réactionnés comportant un transformateur d'adaptation respectivement en entrée et en sortie de l'amplificateur, caractérisé en ce qu'il comporte un transformateur de contre-réaction à double enroulement respectivement relié en entrée et en sortie de chacun des transistors, tel que le drain de chaque transistor est couplé à sa grille respective par le transformateur de contre-réaction d'entrée auquel il est relié et tel que la grille de chaque transistor est couplée à son drain par le transformateur de contre-réaction de sortie auquel elle est reliée, en ce que les sources des deux transistors sont reliées au potentiel de masse de l'alimentation de l'amplificateur, et en ce que les grilles sont reliées respectivement à une extrémité de l'enroulement secondaire du transformateur d'adaptation d'entrée et en ce que les drains sont reliés respectivement à une extrémité de l'enroulement primaire du transformateur de sortie.

L'invention a pour principal avantage qu'elle permet d'améliorer le gain, le rendement et le comportement de l'amplificateur vis-à-vis des problèmes d'adaptation entrée-sortie. Pour cela, on remplace la contre-réaction simple utilisant des résistances entre la sortie et l'entrée de l'amplificateur par une double contre-réaction utilisant uniquement des transformateurs à double enroulement.

D'autres caractéristiques et avantages de l'invention apparaîtront ci-après à l'aide de la description faite en regard des dessins annexés qui représentent :
- La figure 1, un schéma électrique de principe d'un mode de réalisation d'un amplificateur à un seul transistor contre-réactionné par transformateurs,
- La figure 2, le schéma électrique de l'amplificateur de la figure 1 fermé sur un court-circuit,
- La figure 3, une adaptation du schéma de la figure 1 à la réalisation d'un amplificateur push-pull contre-réactionné par transformateurs selon l'invention,
- La figure 4, un schéma simplifié d'une chaîne amplificatrice couplée à une antenne d'émetteur radioélectrique.

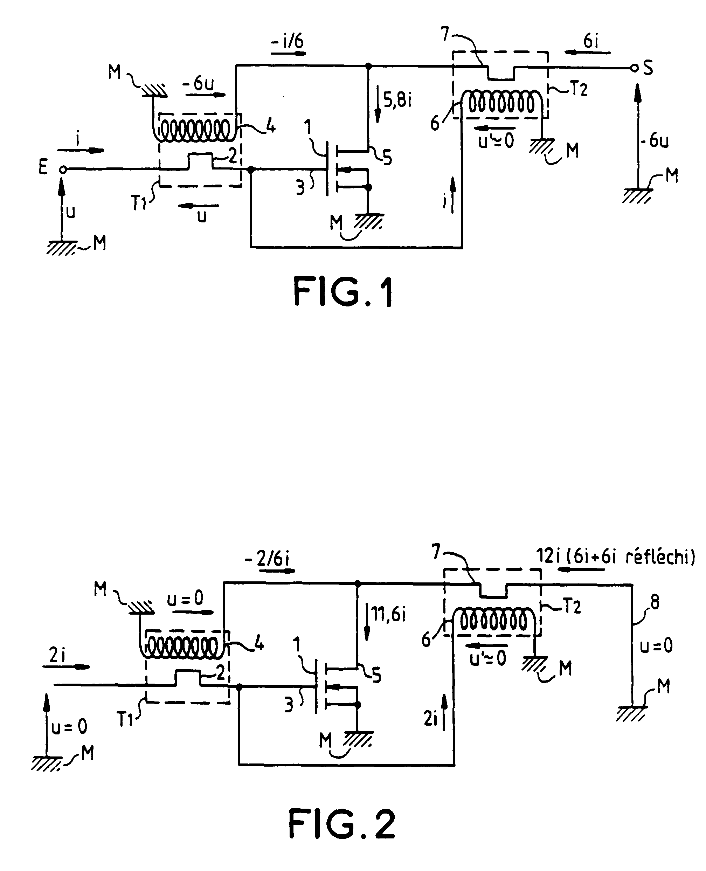

La figure 1 illustre un mode de réalisation d'un amplificateur à un seul transistor MOS contre-réactionné par deux transformateurs permettant de décrire la structure de base d'un amplificateur push-pull selon l'invention qui sera décrit ultérieurement.

L'amplificateur qui est représenté à la figure 1, organisé autour d'un circuit de masse M servant de référence de potentiel, comprend un transistor MOS 1 couplé à deux circuits de contre-réaction formés par deux transformateurs T1 et T2 représentés à l'intérieur d'une ligne discontinue. L'enroulement primaire 2 du transformateur T1 comporte une seule spire n2 = 1. Il est disposé entre l'entrée E de l'amplificateur et la grille 3 du transistor 1. L'enroulement secondaire 4 de ce même transformateur est relié par une de ses extrémités au potentiel de masse de l'amplificateur et par son autre extrémité au drain 5 du transistor 1.

Dans cet exemple, le nombre de spires de l'enroulement secondaire 4 est choisi égal à six, n4=6, ce qui donne comme rapport de transformation en tension du transformateur d'entrée T1: n4/n2= 6.

L'enroulement primaire 6 du transformateur T2 comporte dans cet exemple six spires, n6=6. Il est relié par une de ses extrémités au potentiel de masse M, et par son autre extrémité à la grille 3 du transistor 1.

L'enroulement secondaire 7 comporte une seule spire, n7 = 1, il est disposé entre la sortie S de l'amplificateur et le drain 5 du transistor 1. Le rapport de transformation en courant du transformateur de sortie T2 est de n6/n7 = 6.

Le fonctionnement de l'amplificateur est décrit ci-après en tenant compte des hypothèses suivantes :
- le transistor MOS 1 est idéal, c'est-à-dire que son courant de grille est considéré comme nul, son gain en boucle ouverte infini, et son impédance d'entrée infinie,
- les transformateurs de contre-réaction entrée T1 et sortie T2 sont parfaits, c'est-à-dire que leur résistance de bobinage est considérée comme nulle, le transformateur T2 est considéré comme un transformateur de courant parfait ne développant qu'une tension voisine de zéro aux bornes de ses enroulements primaire et secondaire,
- les impédances d'entrée et de sortie sont identiques.

Dans l'exemple précédent les rapports de transformation des deux transformateurs T1 et T2 respectivement en tension et en courant sont choisis égaux à 6.

Le transformateur T1 assure une contre-réaction série de tension, c'est-à-dire que la grandeur prélevée en sortie de l'amplificateur est une tension, et une grandeur qui lui est proportionnelle est réinjectée en série en entrée de l'amplificateur.

Le transformateur T2 assure une contre-réaction parallèle de courant, c'est-à-dire que la grandeur prélevée en sortie de l'amplificateur est un courant, et une grandeur qui lui est proportionnelle est réinjectée en parallèle sur l'entrée de l'amplificateur.

La description du fonctionnement de l'amplificateur est faite ci-après en raisonnant sur les courants et les tensions mis en jeu dans l'amplificateur :

Un courant i est injecté en entrée de l'amplificateur sur l'enroulement primaire 2 du transformateur d'entrée T1 et une tension u est appliquée entre l'entrée E et le potentiel de masse M. Le potentiel u se retrouve également aux bornes de l'enroulement primaire 2 du transformateur de contre-réaction d'entrée T1, le transistor MOS étant considéré comme parfait et le transformateur T2 comme transformateur de courant idéal avec u'≈0. Sur l'enroulement secondaire 4 du transformateur d'entrée T1 compte tenu du rapport de transformation en tension de l'exemple précédent égal à n4/n2 = 6, se retrouve une tension -6u. Cette tension se retrouve également entre la sortie S de l'amplificateur et le potentiel de masse M.

L'enroulement primaire 6 du transformateur de sortie T2, disposé entre la grille 3 et le potentiel de masse M, est parcouru par le même courant d'entrée i, le transistor 1 étant considéré comme parfait, son courant de grille est nul. L'enroulement secondaire 7 du transformateur de sortie T2 est disposé entre le drain 5 du transistor 1 et la sortie S de l'amplificateur. Compte tenu du rapport de transformation en courant égal au rapport n6/n7 = 6 l'enroulement secondaire 7 est parcouru par un courant qui est également le courant de sortie de l'amplificateur égal à 6i et compte-tenu du rapport de transformation en courant du transformateur d'entrée T1 égal au rapport n2/n4 = 1/6, le courant circulant dans l'enroulement secondaire 4 du transformateur d'entrée T1 est égal à - i/6. Le courant drain est donc égal à -i/6 + 6i = 5,8 i. Le gain de puissance linéaire est donné par le produit du gain en tension et du gain en courant soit dans cet exemple : G_{linéaire} = 36.

Pour expliquer le comportement de l'amplificateur décrit ci-dessus, en présence d'une charge désadaptée le raisonnement suivant part de l'hypothèse d'un cas extrême où la sortie de l'amplificateur est fermée sur un court-circuit 8 correspondant à une impédance de sortie nulle.

Ce cas est illustré par la figure 2 qui représente le circuit de l'amplificateur de la figure 1 fermé sur un court-circuit 8. Sur cette figure, les éléments identiques à la figure 1 sont désignés par les mêmes repères.

L'amplificateur possède un gain linéaire de 36 et il est chargé en sortie par une impédance nulle Zs = 0.

La tension u qui est la tension de sortie de l'amplificateur est nulle, u = 0, et le courant de sortie est la somme du courant incident 6i et du courant réfléchi 6i soit 12i.

Par le jeu des rapports de transformation en courant et tension, le courant d'excitation d'entrée est égal à 2i, le courant circulant dans le secondaire 4 du transformateur d'entrée T1 est égal à (-2/6)i et le courant drain du transistor 1 égal à 11,6 i. La tension d'entrée est égale à la tension u qui est nulle (u = 0). L'impédance d'entrée présentée par l'amplificateur est égale au rapport de la tension d'entrée sur le courant d'entrée, soit Ze = 0.

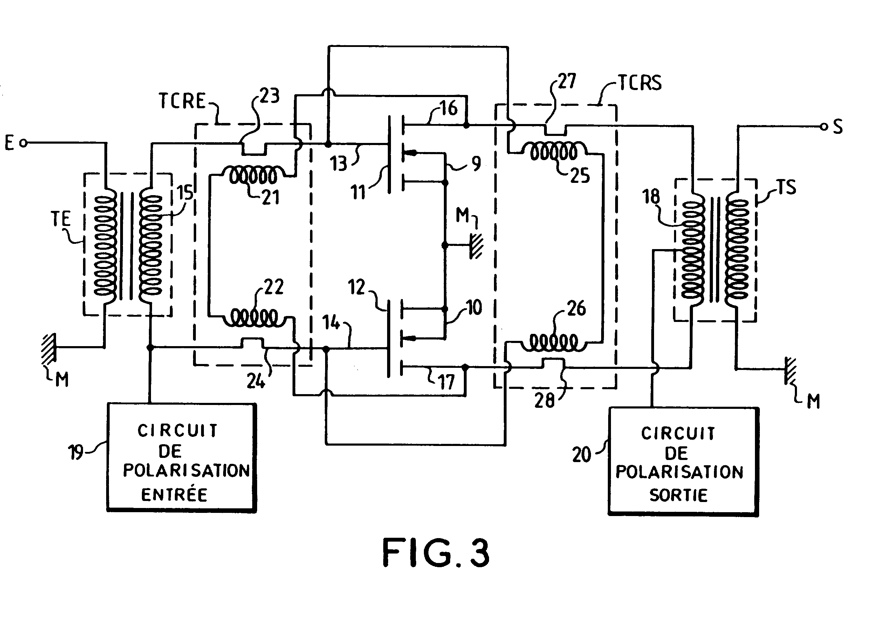

Un tel circuit est, par principe, transmetteur d'impédance, appelé également montage non-inverseur d'impédance. En effet, l'impédance de sortie (Zs = 0) de l'amplificateur est retransmise à son entrée (Ze = 0). L'intérêt de ce circuit est exposé dans la description d'un mode de réalisation d'un amplificateur push-pull selon l'invention décrit ci-après et illustré par la figure 3.

L'adaptation de l'amplificateur qui vient d'être décrit à la réalisation d'un amplificateur de type push-pull est représentée à la figure 3.

Cette adaptation consiste en fait à la réalisation d'un amplificateur de type push-pull connu en soi mais contre-réactionné en entrée et en sortie par des transformateurs à double enroulement selon l'invention

La structure d'un circuit push-pull étant symétrique, on retrouve deux fois la structure de base de l'amplificateur à un seul transistor, décrit précédemment, organisée de la façon suivante :
les sources 9 et 10 des deux transistors MOS 11 et 12 sont reliées entre elles ainsi qu'au potentiel de masse M.

Les grilles 13 et 14 de chaque transistor 11 et 12 sont couplées respectivement à une extrémité de l'enroulement secondaire 15 d'un transformateur d'adaptation Te, représenté à l'intérieur d'une ligne discontinue, en entrée de l'amplificateur, et les drains 16 et 17 de chaque transistor 11 et 12 sont couplés respectivement à une extrémité de l'enroulement primaire 18 d'un transformateur d'adaptation TS, également représenté à l'intérieur d'une ligne discontinue, en sortie de l'amplificateur.

Deux circuits de polarisation 19 et 20 alimentent en continu respectivement les grilles 13 et 14 et les drains 16 et 17 des transistors MOS 11 et 12.

La contre-réaction en entrée et en sortie de l'amplificateur push-pull est assurée par deux transformateurs de contre-réaction en entrée et en sortie des transistors MOS 11 et 12.

Chaque transformateur comporte un double enroulement primaire et secondaire et peut être par exemple conçu avec un ferrite du type connu sous le nom de BALUN.

Le transformateur de contre-réaction d'entrée TCRE, comporte deux enroulements secondaires en série 21 et 22 dont les deux extrémités sont reliées respectivement au drain 16 et 17 de chaque transistor MOS 11 et 12. Chaque enroulement primaire 23 et 24 est disposé respectivement entre les grilles 13 et 14 des transistors 11 et 12 et chacune des extrémités de l'enroulement secondaire 15 du transformateur d'adaptation en entrée TE de l'amplificateur.

Le transformateur de contre-réaction de sortie TCRS comporte deux enroulements primaires en série 25 et 26 dont les deux extrémités sont reliées respectivement à la grille de chaque transistor MOS 11 et 12. Chaque enroulement secondaire 27 et 28 est disposé respectivement entre le drain 16 et 17 des transistors 11 et 12 et chacune des extrémités de l'enroulement primaire 18 du transformateur d'adaptation en sortie TS de l'amplificateur.

Le fonctionnement d'un amplificateur push-pull étant connu, il ne sera pas décrit dans la présente demande de brevet. De même, le fonctionnement des transistors contre-réactionnés par transformateurs étant identique à celui du transistor de la figure 1, il ne sera pas redécrit.

La double contre-réaction ainsi réalisée par transformateurs permet d'obtenir un rendement supérieur à celui obtenu par des résistances de contre-réaction, par exemple, pour une puissance d'entrée identique de 22 dBm à 60 MHz, les entrées et sorties étant chargées par les mêmes impédances, le rendement de l'amplificateur contre-réactionné par transformateurs est de 63,2 %, celui de l'amplificateur contre-réactionné par résistances étant de 48,5 %.

Les résistances de contre-réaction dissipent une certaine puissance intervenant dans le calcul du rendement global de l'amplificateur alors que les transformateurs ne dissipent pratiquement pas de puissance du fait de leur résistance de bobinage très faible. Il y a donc moins de perte d'énergie avec une contre-réaction par transformateurs plutôt qu'avec une contre-réaction par résistances. De plus, les impédances d'entrée et de sortie de l'amplificateur sont plus élevées qu'avec une contre-réaction par résistances, les impédances se rapprochant de l'impédance caractéristique de 50 Ω.

Comme cela a été évoqué précédemment, ce type de circuit transmet l'impédance de sortie de l'amplificateur à son entrée. L'avantage d'un tel circuit est expliqué ci-après.

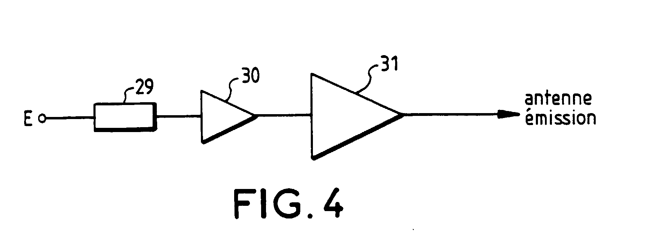

Un amplificateur de puissance est généralement placé en sortie d'une chaîne amplificatrice devant l'antenne émission. Cette chaîne amplificatrice est illustrée par la figure 4.

Cette chaîne amplificatrice comprend de l'entrée vers l'antenne, un atténuateur 29, un préamplificateur 30 et un amplificateur de puissance 31.

En pratique, un TOS de 3 à 10 (taux d'onde stationnaire) présenté par l'antenne émission à la sortie de l'amplificateur de puissance 31, dû à une forte désadaptation de la charge représentant l'antenne, peut causer de graves dommages aux transistors de l'amplificateur de puissance 31 qui est le composant sensible de la chaîne amplificatrice. Pour une même puissance transmise sur charge adaptée, le courant consommé par les transistors augmente et provoque un échauffement des transistors. Le rendement de l'amplificateur 31 s'écroule ainsi que le rendement global de la chaîne amplificatrice. Le rendement est donc sensible à la désadaptation en sortie de la chaîne amplificatrice correspondant à la sortie de l'amplificateur de puissance 31.

Dans un mode de réalisation particulier, l'amplificateur de puissance 31 est l'amplificateur push-pull selon l'invention, l'impédance de sortie de l'amplificateur est donc transmise sur son entrée et correspond également à la sortie du préamplificateur 30 qui est en tête de la chaîne amplificatrice.

En prenant l'exemple du cas extrême où la sortie de l'amplificateur push-pull 31 est court-circuitée, soit une impédance Zs = 0, le préamplificateur 30 voit alors également sur sa sortie une impédance Zs = 0. Il ne transmet donc plus aucune puissance à l'entrée de l'amplificateur push-pull 31 évitant ainsi toute dégradation des transistors qui ne débitent plus de courant.

Dans le cas plus réaliste d'un fort TOS, par exemple un TOS de 8, la forte désadaptation en sortie de l'amplificateur push-pull 31 est transmise directement en sortie du préamplificateur 30, sa puissance de sortie s'écroule et donc la puissance d'excitation de l'amplificateur push-pull 31 diminue évitant ainsi une consommation importante des transistors de l'amplificateur 31.

Suivant le mode de réalisation précédent, un amplificateur push-pull selon l'invention, conforme à celui de la figure 3, a permis d'obtenir les résultats suivants qui sont comparés à titre indicatif avec un amplificateur push-pull, à contre réaction simple sortie-entrée par résistances, placé dans les mêmes conditions que le push-pull à transformateurs :

L'amplificateur selon l'invention fournit une puissance de sortie voisine de 1,9 W sous 6,5 v dans la gamme de fréquence VHF (30-88 MHZ) et accepte une désadaptation en sortie présentant un TOS pouvant atteindre 10.

Une amélioration significative est obtenue sur le TOS de sortie de l'amplificateur selon l'invention qui est ≤ 1,9 contre un TOS ≤ 3,3. Concernant le gain et le rendement pour une fréquence de travail de 60 MHZ et une puissance d'entrée de 21 dBm, le gain en puissance Gp en dB de l'amplificateur selon l'invention reste pratiquement identique à celui de l'amplificateur contre-réactionné par résistances mais le courant dynamique I_{dyn} est seulement de 520 mA pour l'amplificateur selon l'invention contre 710 mA. Ce qui donne un rendement en puissance nettement supérieur: pour le premier 63,2 % et pour le second 48,5 %.

Le comportement sur TOS de l'amplificateur selon l'invention est décrit au sein de la chaîne amplificatrice décrite précédemment et illustré par la figure 4.

Le TOS obtenu dans ces conditions en sortie de l'amplificateur selon l'invention est :

TOS sortie ≤ 2 contre un TOS ≤ 3,5 pour un amplificateur contre-réactionné par résistances placé dans les mêmes conditions.

Le courant d'alimentation de l'amplificateur selon l'invention varie moins sur des désadaptations ramenant des charges faibles. Cette variation n'excède pas 0,8 A pour l'amplificateur selon l'invention contre une variation de 1,2 A pour un amplificateur contre-réactionné par résistances.

En résumé, la double contre-réaction par transformateurs permet une meilleure adaptation en entrée et en sortie de l'amplificateur selon l'invention avec des valeurs d'impédances d'entrée et sortie plus proche de 50 Ω qui est la valeur de l'impédance caractéristique.

Elle permet également d'obtenir un rendement élevé et un meilleur comportement de l'amplificateur vis-à-vis de charges désadaptées.

L'efficacité de la double contre-réaction par transformateurs dépend du choix des rapports de transformation des transformateurs de contre-réaction en entrée et en sortie de l'amplificateur.

Il va de soi que l'invention n'est pas limitée au mode de réalisation précédemment décrit. D'autres variantes sont naturellement possibles notamment le choix de transistors bipolaires à la place des transistors MOS, sans sortir pour autant du cadre de l'invention.

## Revendications

1. Amplificateur de puissance de type push-pull à deux transistors contre-réactionnés comportant un transformateur d'adaptation respectivement en entrée (TE) et en sortie (TS) de l'amplificateur, caractérisé en ce qu'il comporte un transformateur de contre-réaction à double enroulement respectivement relié en entrée (TCRE) et en sortie (TCRS) de chacun des transistors (11 et 12), tel que le drain (16 et 17) de chaque transistor (11 et 12) est couplé à sa grille (13 et 14) respective par le transformateur de contre-réaction d'entrée (TE) auquel il est relié et tel que la grille (13 et 14) de chaque transistor (11 et 12) est couplée à son drain (16 et 17) par le transformateur de contre-réaction de sortie (TCRS) auquel elle est reliée, en ce que les sources (9 et 10) des deux transistors (11 et 12) sont reliées au potentiel de masse (M) de l'alimentation de l'amplificateur, et en ce que les grilles (13 et 14) sont reliées respectivement à une extrémité de l'enroulement secondaire (15) du transformateur d'adaptation d'entrée (TE), et en ce que les drains (16 et 17) sont reliés respectivement à une extrémité de l'enroulement primaire (18) du transformateur de sortie (TS).

2. Amplificateur selon la revendication 1, caractérisé en ce que le transformateur de contre-réaction d'entrée (TCRE) comporte deux enroulements secondaires (21 et 22) reliés en série et dont chaque extrémité est reliée respectivement aux drains (16 et 17) des transistors (11 et 12), et en ce que le transformateur de contre-réaction de sortie (TCRS) comporte deux enroulements primaires (25 et 26), reliés en série et dont chaque extrémité est reliée respectivement aux grilles (13 et 14) des transistors (11 et 12).

3. Amplificateur selon l'une quelconque des revendications précédentes, caractérisé en ce que les deux transistors de l'amplificateur sont des transistors de type MOS.

## Patentansprüche

1. Push-Pull-Leistungsverstärker mit zwei gegengekoppelten Transistoren und je einem Anpassungstransformator (TE, TS) am Eingang und am Ausgang des Verstärkers, dadurch gekennzeichnet, daß er je einen Gegenkopplungstransformator mit doppelter Wicklung (TCRE, TCRS) am Eingang bzw. am Ausgang der beiden Transistoren (11, 12) besitzt, wobei die Drain-Elektrode (16, 17) jedes Transistors (11, 12) mit seiner eigenen Gate-Elektrode (13, 14) über den Gegenkopplungstransformator (TCRE) am Eingang gekoppelt ist, an den er angeschlossen ist, und wobei die Gate-Elektrode (13, 14) jedes Transistors (11, 12) mit seiner eigenen Drain-Elektrode (16, 17) über den Gegenkopplungstransformator (TCRS) am Ausgang gekoppelt ist, an den er angeschlossen ist, daß die Source-Elektroden (9, 10) der beiden Transistoren (11, 12) mit dem Massepotential (M) der Speisequelle des Verstärkers verbunden sind und daß die Gate-Elektroden (13, 14) an je ein Ende der Sekundärwicklung (15) des Anpassungstransformators (TE) am Eingang und die Drain-Elektroden (16, 17) an je ein Ende der Primärwicklung (18) des Anpassungstransformators (TS) am Ausgang angeschlossen sind.

2. Verstärker nach Anspruch 1, dadurch gekennzeichnet, daß der Gegenkopplungstransformator (TCRE) am Eingang zwei Sekundärwicklungen (21, 22) besitzt, die in Reihe geschaltet sind und deren übrige Anschlüsse je mit der Drain-Elektrode (16, 17) eines der Transistoren (11, 12) verbunden sind, und daß der Gegenkopplungstransformator (TCRS) am Ausgang zwei Primärwicklungen (25, 26) enthält, die in Reihe geschaltet sind und deren übrige Anschlüsse je mit der Gate-Elektrode (13, 14) eines der Transistoren (11, 12) verbunden sind.

3. Verstärker nach einem beliebigen der vorhergehenden Ansprüche, dadurch gekennzeichnet, daß die beiden Transistoren des Verstärkers MOS-Transistoren sind.

## Claims

1. Power amplifier of push-pull type with two fedback transistors including a transformer for matching respectively at input (TE) and at output (TS) of the amplifier, characterized in that it includes a feedback transformer with double winding respectively linked at input (TCRE) and at output (TCRS) of each of the transistors (11 and 12), such that the drain (16 and 17) of each transistor (11 and 12) is coupled to its respective gate (13 and 14) by the input feedback transformer (TE) to which it is linked and such that the gate (13 and 14) of each transistor (11 and 12) is coupled to its drain (16 and 17) by the output feedback transformer (TCRS) to which it is linked, in that the sources (9 and 10) of the two transistors (11 and 12) are linked to the earth potential (M) of the amplifier supply, and in that the gates (13 and 14) are linked respectively to one end of the secondary winding (15) of the input matching transformer (TE), and in that the drains (16 and 17) are linked respectively to one end of the primary winding (18) of the output transformer (TS).

2. Amplifier according to Claim 1, characterized in that the input feedback transformer (TCRE) includes two secondary windings (21 and 22) linked in series and each end of which is linked respectively to the drains (16 and 17) of the transistors (11 and 12), and in that the output feedback transformer (TCRS) includes two primary windings (25 and 26), linked in series and each end of which is linked respectively to the gates (13 and 14) of the transistors (11 and 12).

3. Amplifier according to either one of the preceding claims, characterized in that the two transistors of the amplifier are MOS type transistors.
